# EUROPEAN PATENT APPLICATION

(11) **EP 4 645 104 A1**
(43) Date of publication of application: **05.11.2025**
(21) Application number: 24173413.6
(22) Date of filing: 30.04.2024
(51) Int. Cl.: G06F 13/40, G05B 19/042, G05B 19/05, H05K 7/14

(54) **IO SIGNAL HANDLING ARRANGEMENT AND PROCESS CONTROL SYSTEM COMPRISING AN IO SIGNAL HANDLING ARRANGEMENT**

(71) Applicant: ABB SCHWEIZ AG, 5400 Baden (CH)
(72) Inventor: NORBERG, Robert, 632 23 Eskilstuna (SE); HANSSON, Ulf, 722 10 Västerås (SE); BERGLINN, Rune, 724 61 Västerås (SE); BERGQVIST, Joakim, 811 98 Österfärnebo (SE); PETTERSSON, Göran, 726 30 Skultuna (SE); TAFT, Mark, Palm Harbor, 34685 (US)
(74) Representative: Kransell & Wennborg KB

(57) **Abstract**

An IO signal handling arrangement comprises an adapter (30) having a first set of connection terminals (32) connected to a first set of connection terminals of a first base plate, a second set of connection terminals (34) connected to a second set of connection terminals of the base plate, a third set of connection terminals (36) connected to a first set of connection terminals of a first IO module, a fourth set of connection terminals (36) connected to a second set of connection terminals of the first IO module, a first set of conductors (54) between the first and third sets of connection terminals (32) and a second set of conductors (56) drawn between the second and fourth sets of connection, where the first set of conductors (54) are adapted to carry field device signals and the second set of conductors (56) are adapted to carry IO bus signals.

## Description

### FIELD OF THE INVENTION

The present invention relates to an Input Output (IO) signal handling arrangement as well as to a process control system comprising such an IO signal handling arrangement.

### BACKGROUND

An industrial process in a process control system may be controlled by a controller. In the providing of such control the controller may communicate with field devices via Input Output (IO) modules, which IO modules may be provided in different IO module families.

An IO module may then be connected to a base plate that holds field wiring to the field devices or field instruments.

It is also possible to connect several base plates to each other in order to form an IO bus via the base plates, which IO bus is used for communication between the controller and IO modules connected to the base plates. US 2016/0191418 and US 2020/033758 disclose different ways in which interconnections can be made.

After a number of years in use the IO modules may need replacing. If the IO module family installed from the beginning is still being manufactured and sold, the replacement is very easy, just install a new IO module of the same type.

However, if the IO module family is no longer sold, replacement becomes more complex since IO modules are normally mounted on a base plate that holds the field wiring to the instruments. Removing the field wiring and installing a new base plate and a new I/O module of different model/family could require a new loop check of the installation. This can be time consuming since the field wires have been toughed. In a large project with 15,000 instruments this means that one could need to remove about 30,000 field wires and install them on the new I/O system. After this all 15,000 instruments may need to be tested to make sure that there are no wiring errors.

There is thus a need for simplifying the replacing of an old IO module with a new IO module.

WO 2022/191284 discloses one way of simplifying such replacing. According to WO 2022/191284 an adapter is placed on a terminal block to which wiring is connected. The terminal block could be considered to be a base plate. An IO module may then be connected to the adapter. Furthermore, it is possible to interconnect the adapters with each other using a communication connection component.

### SUMMARY OF THE INVENTION

The invention therefore aims at providing an improvement in the way that IO modules are connected to base plates in a process control system.

This object is achieved through an Input Output, IO, signal handling arrangement comprising:
- an adapter having a first set of connection terminals for connection to a corresponding first set of connection terminals of a first base plate, a second set of connection terminals for connection to a corresponding second set of connection terminals of the first base plate, a third set of connection terminals for connection to a corresponding first set of connection terminals of a first IO module, a fourth set of connection terminals for connection to a corresponding second set of connection terminals of the first IO module, a first set of conductors drawn between the first set of connection terminals and the third set of connection terminals and a second set of conductors drawn between the second set of connection terminals and the fourth set of connection terminals,
wherein the first set of conductors are adapted to carry field device signals between field devices connected to the first base plate and the first IO module and the second set of conductors are adapted to carry IO bus signals between the first IO module and an IO bus at least partly provided through the first base plate.

The first set of conductors may with advantage run in the interior of the adapter. Also the second set of conductors may with advantage run in the interior of the adapter.

The first set of connection terminals, the first set of conductors and the third set of connection terminals of the adapter may provide a first number of electrical connections between the first set of connection terminals of the first base plate and the first set of connection terminals of the first IO module, while the second set of connection terminals, the second set of conductors and the fourth set of connection terminals of the adapter may provide a second number of electrical connections between the second set of connection terminals of the first base plate and the second set of connection terminals of the first IO module.

In this case it is additionally possible that the second number of electrical connections between the second set of connection terminals of the first base plate and the second set of connection terminals of the first IO module is lower than the number of connection terminals in the second set of connection terminals of the first base plate.

The number of conductors in the second set of conductors of the adapter may be lower than the number of connection terminals in the second set of connection terminals of the first base plate. Additionally or instead, the number of connection terminals in the second set of connection terminals of the adapter may be lower than the number of connection terminals in the second set of connection terminals of the first base plate. The number may especially be lower if the connection terminals in the second set of connection terminals of the adapter are male connection terminals.

One connection terminal of the second set of connection terminals of the first base plate for which there is an electrical connection to the second set of connection terminals of the first IO module may be provided for an IO bus signal that is a first voltage feed signal and at least one connection terminal of the second set of connection terminals of the first base plate lacking an electrical connection to the second set of connection terminals of the first IO module may be provided for an IO bus signal that is a second voltage feed signal. Additionally or instead one connection terminal of the second set of connection terminals of the first base plate for which there is an electrical connection to the second set of connection terminals of the first IO module may be provided for an IO bus signal that is a first clock signal and at least one connection terminals of the second set of connection terminals of the first base plate lacking an electrical connection to the second set of connection terminals of the first IO module may be provided for an IO bus signal that is a second clock signal.

The IO signal handling arrangement may also comprise the first IO module. The IO signal handling arrangement may additionally or instead comprise the first base plate.

The first base plate may comprise a first set of conductors forming at least a part of the IO bus, where the first set of conductors stretch from a first side of the first base plate to a second side of the first base plate, and where each connection terminal in the second set of connection terminals is electrically connected to a corresponding conductor in the first set of conductors. The first set of conductors may additionally stretch between a third set of connection terminals of the first base plate and a fourth set of connection terminals of the first base plate, thereby allowing the IO bus to be formed by more than one base plate. This first set of conductors may with advantage run in the interior of the first base plate.

The number of electrical connections in the second number of electrical connections of the adapter may in this case also be lower than the number of conductors in the first set of conductors of the first base plate.

The first base plate may also comprise a fifth set of connection terminals and a second set of conductors interconnecting the first set of connection terminals with the fifth set of connection terminals. This second set of conductors may also with advantage run in the interior of the first base plate.

The IO signal handling arrangement may additionally comprise at least one field device in a first group of field devices connected to the first base plate via the fifth set of connection terminals.

The above-mentioned object is also achieved through a process control system comprising the previously-mentioned IO signal handling arrangement.

The process control system may also comprise a controller connected to the IO bus for communicating with the first IO module.

The process control system may additionally comprise IO fieldbus/network interfaces, fieldbuses and networks. The controllers and IO fieldbus/network interfaces connects to the fieldbuses or networks. The IO fieldbus/network interfaces connect the I/O modules via a local IO bus.

In a typical fieldbus implementation a controller connects to one or many IO fieldbus/network interfaces.

In a typical network implementation one or many controllers connects to one or many IO fieldbus/network interfaces, the controllers can in this case communicate with any IO module on any IO bus via the different IO fieldbus/network interfaces. It is even possible that more than one controller is reading data from a specific I/O module.

Thus, the controller may be connected to a first side of the IO fieldbus/network interface via a network or a field bus and the IO bus may be connected to a second side of the IO fieldbus/network interface.

The first IO module may perform signal conditioning of IO signals and optionally also analog-to-digital (A/D) or digital-to-analog (D/A) conversion.

The IO signal handling arrangement may comprise a second base plate, which may be attachable to the first or second side of the first base plate and which may also contribute to the forming of the IO bus.

### BRIEF DESCRIPTION OF THE DRAWINGS

The present invention will in the following be described with reference being made to the accompanying drawings, where
Fig. 1 shows a view from above of an IO signal handling arrangement comprising a first base plate, an adapter and a first IO module,
Fig. 2 shows a view from below of the adapter and first IO module,
Fig. 3 schematically shows a side view of the adapter and first IO module,
Fig. 4A shows a side view of a first lateral side of the first base plate,
Fig 4B schematically shows a side view of a second lateral side of the first base plate,
Fig. 5 shows a view from above of two interconnected base plates, and
Fig. 6 schematically shows a process control system comprising a controller connected to a number of IO modules via a field bus, IO fieldbus/network interface and IO bus, where the IO modules are connected to field devices.

### DETAILED DESCRIPTION OF THE INVENTION

In the following there will be given a detailed description of embodiments of an Input Output (IO) signal handling arrangement comprising an adapter. The IO signal handling arrangement may also comprise an IO module and/or a base plate. It should furthermore be realized that the IO signal handling arrangement may comprise more base plates and/or more IO modules and more adapters. Also a process control system comprising a signal handling arrangement will be described.

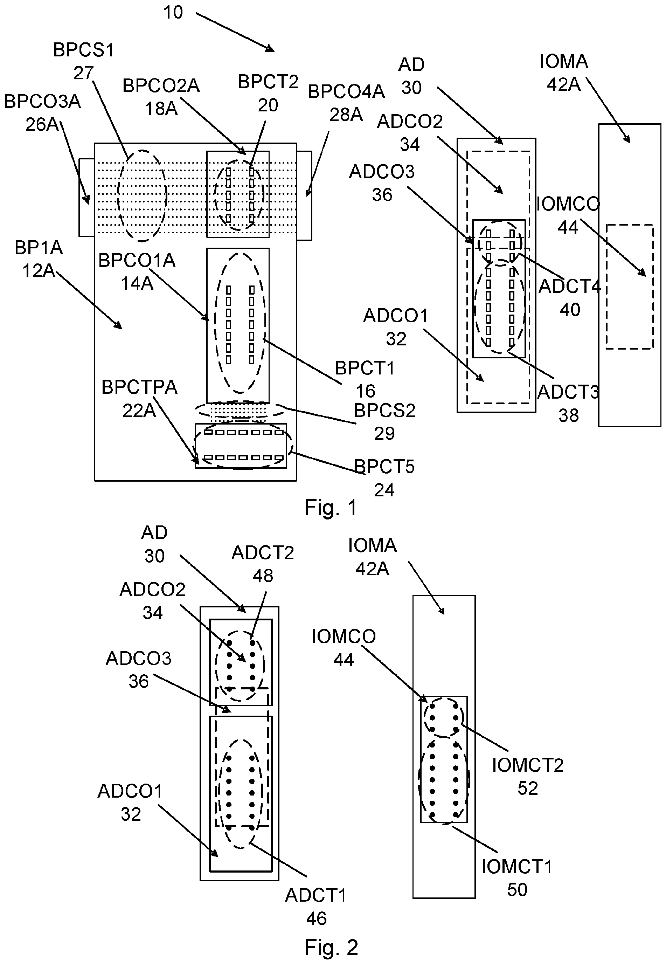

Fig. 1 shows a view from above of an IO signal handling arrangement 10 for a process control system. The IO signal handling arrangement 10 comprises a first base plate BP1A 12A, an adapter AD 30 and a first IO module IOMA 42A. The figure shows an upper or front side of the first base plate 12A, adapter 30 and first IO module 42A. In the figure elements that appear on a bottom side of the adapter 30 and first IO module 42A are shown with dashed lines and elements that are provided in the interior of the first base plate 12A are shown with dotted lines. Furthermore, sets of conductors are encircled by dashed ellipses.

Fig. 2 shows a view from below of the adapter 30 and first IO module 42A, i.e. a view of the bottom side of the adapter 30 and first IO module 42A, where elements that appear on the top or front side are shown with dashed lines.

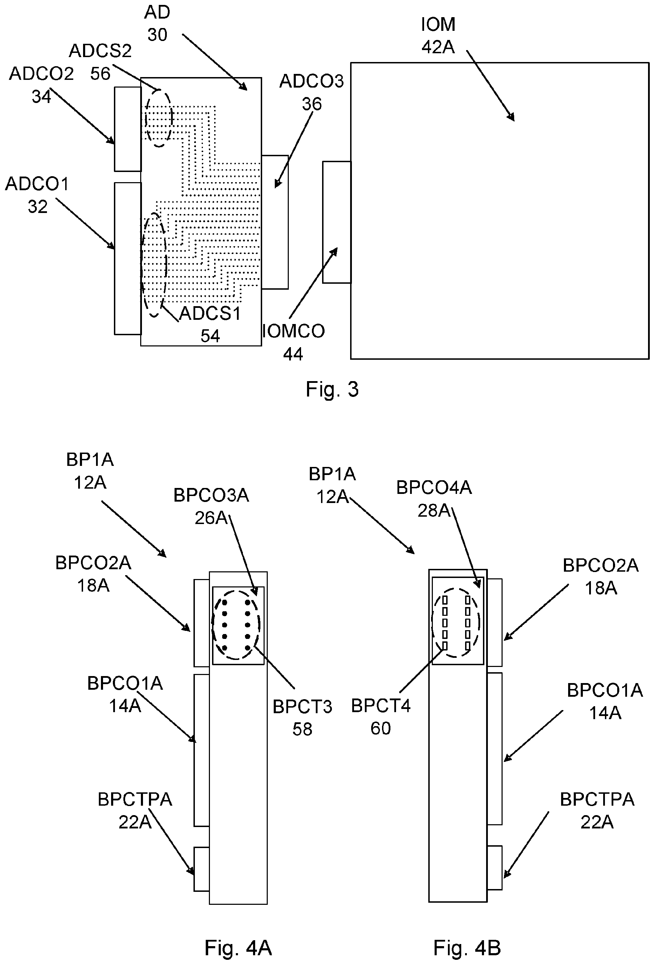

Fig. 3 shows a side view of the adapter 30 and first IO module 42A, i.e. a view of a lateral side provided between the top and bottom sides of the adapter and first IO module 42A, respectively. In the figure elements that appear in the interior of the adapter 30 are shown with dotted lines.

Fig. 4A shows a side view of a first lateral side of the first base plate 12A, i.e. a first lateral side provided between the top and bottom sides of the base plate 12A. Fig. 4B shows a view of a second lateral side of the first base plate, i.e. a second lateral side provided between the top and bottom sides of the first base plate 12A.

The first base plate 12A comprises a number of connectors and a connection terminal panel.

More particularly, it comprises a first base plate connector BPCO1A 14A comprising a first set of base plate connection terminals BPCT1 16, a second base plate connector BPCO2A 18A with a second set of base plate connection terminals BPCT2 20, a third base plate connector BPCO3A 26A with a third set of base plate connection terminals BPCT3 58 and a fourth base plate connector BPCO4A 28A with a fourth set of base plate connection terminals BPCT4 60. Here the first connector 14A comprising the first set of connection terminals 16 and the second connector 18A with the second set of connection terminals 20 are provided on the front side of first base plate12A, while the third connector 26A with the third set of connection terminals 58 is provided on the first lateral side of the first base plate 12A and the fourth connector 28A with the fourth set of connection terminals 60 is provided on the second lateral side of the first base plate 12A.

The third and fourth connectors 26A, 28A with the third and fourth sets of connection terminals 58, 60 may be provided in order to allow an IO bus to be formed. For this reason, a first set of base plate conductors BPCS1 27 runs between the third and fourth sets of connection terminals 58, 60, preferably in the interior of the first base plate 12A. Thus, the first set of conductors 27 stretch from the first lateral side of the first base plate 12A to the second lateral side of the first base plate 12A. Each connection terminal of the third set of connection terminals 58 may be electrically connected to a corresponding connection terminal of the fourth set of connection terminals 60 using a dedicated conductor in the first set of conductors 27 of the first base plate 12A.

Furthermore, each connection terminal in the second set of connection terminals 20 of the second connector 18A is electrically connected to a corresponding conductor in the first set of conductors 27.

The first base plate 12A also comprises a base plate connection terminal panel BPCTPA 22A, with advantage on the front side, to which connection terminal panel 22A field wiring of field devices may be connected. Wires leading to field devices may thus be connected to the connection terminal panel 22A. The connection terminal panel 22A may for this reason comprise a fifth set of base plate connection terminals BPCT5 24, where each connection terminal is provided for connection to a field wire of a field device. Each field device may be connected to the connection terminal panel 22A with two field wires. However, also other numbers are possible, such as one, three or four wires. Thus, the fifth set of connection terminals 24 comprises connection terminals to which it is possible to connect wires of field devices of a process control system, such as a first set of wires leading to a first group of field devices. The fifth set of connection terminals 24 of the connection terminal panel 22A are connected to the first set of connection terminals 16 of the first connector 14A via a second set of base plate conductors BPCS2 29, which second set of conductors 29 with advantage run in the interior of the first base plate 12A. Each connection terminal of the fifth set of connection terminals 24 may be connected to a corresponding connection terminal of the first set of connection terminals 16 via a dedicated conductor in the second set of conductors 29. Thus, the connection terminals of the fifth set of connection terminals 24 are interconnected within the first base plate 12A with corresponding connection terminals of the first set of connection terminals 16.

The adapter 30 may also have a front side and a bottom side, where the bottom side may be provided with a first adapter connector ADCO1 32 comprising a first set of adapter connection terminals ADCT1 46 and a second adapter connector ADCO2 34 comprising a second set of adapter connection terminals ADCT2 48. The front side may in turn be provided with a third adapter connector ADCO3 36 comprising a third set of adapter connection terminals ADCT3 38 and a fourth set of adapter connection terminals ADCT4 40. It should here be realized that as an alternative the third and fourth sets of connection terminals 38, 40 may be provided in separate connectors.

There is also a first set of conductors ADCS1 54 and a second set of conductors ADCS2 56 running between the front and bottom sides of the adapter 30, with advantage in the interior of the adapter 30. The first set of conductors 54 are drawn between the first set of connection terminals 46 and the third set of connection terminals 38, while the second set of conductors 56 is drawn between the second set of connection terminals 48 and the fourth set of connection terminals 40. Each connection terminal in the third set of connection terminals 38 may be connected to a corresponding connection terminal of the first set of connection terminals 46 via a dedicated conductor in the first set of conductors 54 and each connection terminal in the fourth set of connection terminals 40 may be connected to a corresponding connection terminal in the second set of connection terminals 48 via a dedicated conductor in the second set of conductors 56.

Finally, the first IO module IOMA 42A has an IO module connector IOMCO 44, for instance provided on a bottom side, comprising a first set of IO module connection terminals IOMCT1 50 and a second set of IO module connection terminals IOMCT2 52. It should also here be realized that as an alternative the first and second sets of connection terminals 50, 52 may be provided in separate connectors.

The first IO module may be any type of IO module operating on Input Output (IO) signals of any type of field device, which operating may typically involve signal conditioning and optionally also analog-to-digital (A/D) or digital-to-analog (D/A) conversion. Thus, it may operate on all types of IO signals, such as Analog Input (AI), Analog Output (AO), Digital Input (DI), Digital Output (DO), Highway Addressable Remote Transducer (HART), Resistance temperature detector (RTD), Thermocoupler (TC) and NAMUR signals, where NAMUR is an abbreviation for Normenarbeitsgemeinschaft für Mess- und Regeltechnik in der chemischen Industrie". The IO signals may additionally have different voltage levels, such as 24V, 48V, 120V and 230V.

The first IO module 42A needs to communicate with an IO bus provided via the first set of conductors 27 of the first base plate 12A as well as with field devices connected to the first base plate 12A via the base plate connection terminal panel 22A. Therefore, the first set of connection terminals 46 of the adapter 30 is provided for connection to the first set of connection terminals 16 of the first base plate 12A and the second set of connection terminals 48 of the adapter 30 is provided for connection to the second set of connection terminals 20 of the first base plate 12A. Moreover, the third set of connection terminals 38 of the adapter 30 are provided for connection to the first set of connection terminals 50 of the first IO module 42A and the fourth set of connection terminals 40 of the adapter 30 are provided for connection to the second set of connection terminals 52 of the first IO module 42A.

Thereby the first set of connection terminals 46, the first set of conductors 54 and the third set of connection terminals 38 of the adapter 30 provide a first number of electrical connections between the first set of connection terminals 16 of the first base plate 12A and the first set of connection terminals 50 of the first IO module 42A and the second set of connection terminals 48, the second set of conductors 56 and the fourth set of connection terminals 40 of the adapter 30 provide a second number of electrical connections between the second set of connection terminals 20 of the first base plate 12A and the second set of connection terminals 52 of the first IO module 42A.

The connection terminals in the first set of connection terminals 16 of the first base plate 12A and the connection terminals in first set of connection terminals 46 of the adapter 30 may be able to mate with each other. For instance, the connection terminals in one set may be realized as female connection terminals and the connection terminals in the other set as male connection terminals. The same can be said about the connection terminals in the second set of connection terminals 20 of the first base plate 12A and the second set of connection terminals 48 of the adapter 30. They may thus be able to mate with each other, such as through being male or female. The connection terminals in the third set of connection terminals 38 of the adapter 30 may be able to mate with the connection terminals in first set of connection terminals 50 of the first IO module 42A and the connection terminals in the fourth set of connection terminals 40 of the adapter 30 may be able to mate with the connection terminals in second set of connection terminals 52 of the first IO module 42A. As an example, the connection terminals in the first and second sets of connection terminals 16, 20 in the first base plate 12A and the connection terminals in the third and fourth sets of connection terminals 38, 40 in the adapter 30 may be female connection terminals, while the connection terminals in the first and second sets of connection terminals 46, 48 in the adapter and the connection terminals in the first and second sets of connection terminals 50, 52 of the first IO module 42A may be male connection terminals.

When the adapter 30 is connected to the first base plate 12A and the first IO module 42A is connected to the adapter 30, the first set of conductors 54 of the adapter 30 carry field device signals between field devices connected to the first base plate 12A and the first IO module 42A and the second set of conductors 56 of the adapter 30 carry IO bus signals between the first IO module 42A and an IO bus at least partly provided through the first set of conductors 27 of the first base plate 12A.

It is possible that the first IO module 42A does not need to communicate with all the conductors of the first set of conductors 27 of the first base plate 12A.

For this reason, the second number of electrical connections between the second set of connection terminals 20 of the first base plate 12A and the second set of connection terminals 52 of the first IO module 42A may be lower than the number of connection terminals in the second set of connection terminals 20 of the first base plate 12A and also lower than the number of conductors in the first set of conductors 27 of the first base plate 12A. This may be realized through the number of conductors in the second set of conductors 56 of the adapter 30 being lower than the number of connection terminals in the second set of connection terminals 20 of the first base plate 12A. Depending on type of connection terminal used in the second set of connection terminals 48 of the adapter 30, this may also involve the number of connection terminals in the second set of connection terminals 48 of the adapter 30 being lower than the number of connection terminals in the second set of connection terminals 20 of the first base plate 12A. The number of connection terminals may especially be lower if they are of the male type.

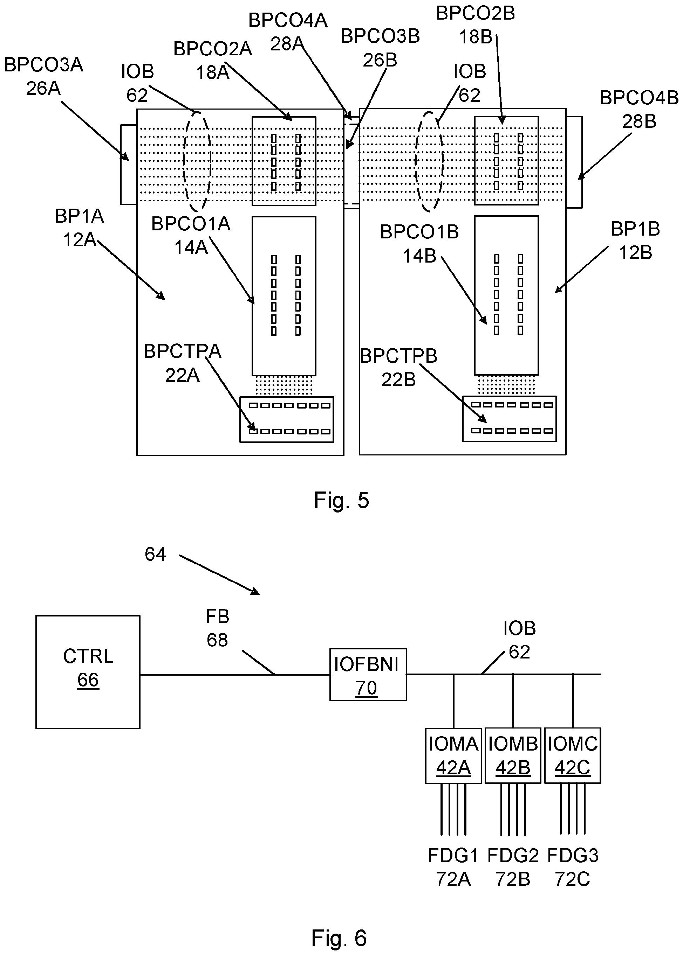

As was mentioned above, it is possible that the first set of conductors 27 in the first base plate 12A are used to form an IO bus. An IO bus may be formed through interconnecting more than one base plate. How this can be done can be seen in fig. 5, which shows a view from above of two interconnected base plates.

In this case both the first base plate BP1A 12A and a second base plate BP1B 12B may be equipped with a third base plate connector BPCO3A 26A, BPCO3B 26B comprising a third set of base plate connection terminals BPCT3 58 with one connector type realization, here exemplified by a female connection terminal type realization, and a fourth base plate connector BPCO4A 28A, BPCO4B 28B comprising a fourth set of base plate connection terminals BPCT4 60 with another connector type realization, here exemplified by a male connection terminal type realization.

It is then possible to interconnect the first set of conductors of the first base plate 12A with the first set of conductors of the second base plate 12B through for instance interconnecting the third connector 26B of the second base plate 12B with the fourth connector 28A of the first base plate 12A or vice versa. In this way the IO bus can be formed through connecting base plates to each other.

The second base plate 12B may thus be attachable to the first or the second lateral side of the first base plate and may also contribute to the forming of the IO bus.

As has been mentioned earlier, an IO module is typically provided in a process control system for enabling communication between a controller and field devices.

The process control system may additionally comprise IO fieldbus/network interfaces, fieldbuses and networks. The controllers and IO fieldbus/network interfaces connects to the fieldbuses or networks. The IO fieldbus/network interfaces connects the IO modules via an local IO bus.

Fig. 6 schematically shows one such process control system 64 comprising a controller CTRL 66 connected to the IO bus IOB 62 via a field bus FB 68 and an IO field bus/network interface IOFBNI 70 for communicating with IO modules, such as the first IO module 42A. The controller 66 is connected to a first side of the IO fieldbus/network interface 62 via the field bus 68 and the IO bus 62 is connected to a second side of the IO fieldbus/network interface 70 8.

As an alternative, the controller may be connected to the IO fieldbus/network interface via a network.

In a typical fieldbus implementation a controller connects to one or many IO fieldbus/network interfaces.

In a typical network implementation one or many controllers connects to one or many IO fieldbus/network interfaces, the controllers can in this case communicate with any IO module on any IO bus via the different IO fieldbus/network interfaces, it is even possible that more than one controller is reading data from a specific IO module.

In the example in fig. 6, the first IO module IOMA 42A is connected together with a second and a third IO module, IOMB 42B, IOMC 42C to the IO bus 62, where the IO bus 62 and field device connection is realized using a number of base plates and where at least one of the IO modules is connected to the corresponding base plate via a dedicated adapter (not shown). Each IO module 42A, 42B, 42C is then connected to a corresponding group of field devices, each comprising at least one field device, via its dedicated base plate. As an example, the first IO module 42A is connected to a first group of field devices FDG1 72A, the second IO module 42B is connected to a second group of field devices FDG2 72B and the third IO module 42C is connected to a third group of field devices FDG3 72C.

The provision of the adapter 30 allows the change of IO module without having to change the field device connections, which saves a lot of effort and also avoids the need for investigation of faulty connections.

Furthermore, it is possible that that new IO modules do not need all the bus signals that are present on the IO bus 62. The IO bus 62 may for instance provide a first and a second feeding voltage, where a new IO module, for instance the first IO module 42A, may only need the first feeding voltage, but not the second. Additionally or instead, the IO bus 62 may provide a first and a second clock signal, where the new IO module may only need the first clock signal, but not the second. Then it is unnecessary for these signals to reach the new IO module.

In order to achieve this for the first IO module 42A being connected to the first base plate 12A via the adapter 30, one connection terminal of the second set of connection terminals 20 of the first base plate 12A for which there is an electrical connection to the second set of connection terminals 52 of the first IO module 42A may be provided for an IO bus signal that is the first voltage feed signal and at least one connection terminal of the second set of connection terminals 20 of the first base plate 12A lacking an electrical connection to the second set of connection terminals 52 of the first IO module 42A may be provided for an IO bus signal that is or was the second voltage feed signal.

In a similar manner, one connection terminal of the second set of connection terminals 20 of the first base plate 12A for which there is an electrical connection to the second set of connection terminals 52 of the first IO module 42A is provided for an IO bus signal that is the first clock signal and at least one connection terminal of the second set of connection terminals 20 of the first base plate 12A lacking an electrical connection to the second set of connection terminals 52 of the first IO module 42A may be provided for an IO bus signal that is or was the second clock signal.

These signals are merely examples of signals that may be superfluous. It is possible that also other signals on the IO bus are superfluous.

The above-mentioned IO bus signals are typically provided to the IO bus via the field bus 68. Data signals on the IO bus 62 may need to be coded for transmission to the controller using a Fieldbus data coding format, which coding may be performed by the IO fieldbus/network interface 70. Alternatively the IO modules may have such coding functionality, in which case the IO fieldbus/network interface may be omitted.

Through this change it is also possible to allow any old IO module to keep receiving the signals that a new IO module does not need at the same time as the new IO module only receives the signals that it needs.

The base plate and the wiring to the instruments can remain untouched. Furthermore, the use of the adapter 30 also allows for the new IO module to have different connectors to the base plate than an old IO module. It can also have different dimensions.

It is also possible that the bus communication is set to use a new bus communication protocol. In this case it is possible to reuse the existing bus infrastructure of the old base plate, but not all lines of the old bus are reused, only a subset of them.

As was mentioned earlier, the IO signal handling arrangement may in its simplest for only compromise the adapter. According to a variation it may also comprise the first IO module. According to another variation it may instead or additionally comprise the first base plate. According to further variations the IO signal handling arrangement comprises more base plates, more adapters and/or more IO modules.

## Claims

1. An Input Output, IO, signal handling arrangement (10) comprising:
- an adapter (30) having a first set of connection terminals (46) for connection to a corresponding first set of connection terminals (16) of a first base plate (12A), a second set of connection terminals (48) for connection to a corresponding second set of connection terminals (20) of the first base plate (12A), a third set of connection terminals (38) for connection to a corresponding first set of connection terminals (50) of a first IO module (42A), a fourth set of connection terminals (40) for connection to a corresponding second set of connection terminals (52) of the first IO module (42A), a first set of conductors (54) drawn between the first set of connection terminals (46) and the third set of connection terminals (38) and a second set of conductors (56) drawn between the second set of connection terminals (48) and the fourth set of connection terminals (40),
- wherein the first set of conductors (54) are adapted to carry field device signals between field devices (72A) connected to the first base plate (12A) and the first IO module (42A) and the second set of conductors (56) are adapted to carry IO bus signals between the first IO module (42A) and an IO bus (62) at least partly provided through the first base plate (12A).

2. The IO signal handling arrangement (10) according to claim 1, wherein the first set of connection terminals (46), the first set of conductors (54) and the third set of connection terminals (38) of the adapter (30) provide a first number of electrical connections between the first set of connection terminals (16) of the first base plate (12A) and the first set of connection terminals (50) of the first IO module (42A) and the second set of connection terminals (48), the second set of conductors (56) and the fourth set of connection terminals (40) of the adapter (30) provide a second number of electrical connections between the second set of connection terminals (20) of the first base plate (12A) and the second set of connection terminals (52) of the first IO module (42A), wherein the second number of electrical connections between the second set of connection terminals (20) of the first base plate (12A) and the second set of connection terminals (52) of the first IO module (42A) is lower than the number of connection terminals in the second set of connection terminals (20) of the first base plate (12A).

3. The IO signal handling arrangement (10) according to claim 2, wherein the number of conductors in the second set of conductors (56) of the adapter (30) is lower than the number of connection terminals in the second set of connection terminals (20) of the first base plate (12A).

4. The IO signal handling arrangement (10) according to claim 2 or 3, wherein the number of connection terminals in the second set of connection terminals (48) of the adapter (30) is lower than the number of connection terminals in the second set of connection terminals (20) of the first base plate (12A).

5. The IO signal handling arrangement (10) according to any of claims 2 - 4, whereinone connection terminal of the second set of connection terminals (20) of the first base plate (12A) for which there is an electrical connection to the second set of connection terminals (52) of the first IO module (42A) is provided for an IO bus signal that is a first voltage feed signal and at least one connection terminal of the second set of connection terminals (20) of the first base plate (12A) lacking an electrical connection to the second set of connection terminals (52) of the first IO module (42A) is provided for an IO bus signal that is a second voltage feed signal.

6. The IO signal handling arrangement (10) according to any of claims 2 - 5, wherein one connection terminal of the second set of connection terminals (20) of the first base plate (12) for which there is an electrical connection to the second set of connection terminals (52) of the first IO module (42A) is provided for an IO bus signal that is a first clock signal and at least one connection terminals of the second set of connection terminals (20) of the first base plate (12) lacking an electrical connection to the second set of connection terminals (52) of the first IO module (42A) is provided for an IO bus signal that is a second clock signal.

7. The IO signal handling arrangement (10) according any previous claim, further comprising the first IO module (42A).

8. The IO signal handling arrangement (10) according to any previous claim, further comprising the first base plate (12A).

9. The IO signal handling arrangement (10) according to claim 8, wherein the first base plate (12A) comprises a first set of conductors (27) forming at least a part of the IO bus ( 62), said first set of conductors (27) stretching from a first side of the first base plate (12A) to a second side of the first base plate (12A), where each connection terminal in the second set of connection terminals (20) is electrically connected to a corresponding conductor in the first set of conductors (27).

10. The IO signal handling arrangement (10) according to claim 9, wherein the first set of conductors (27) stretch between a third set of connection terminals (58) of the first base plate (12A) and a fourth set of connection terminals (60) of the first base plate (12A) thereby allowing the IO bus (62) to be formed by more than one base plate (12A, 12B).

11. The IO signal handling arrangement (10) according to any of claims 8 - 10, wherein the first base plate (12A) comprises a fifth set of connection terminals (24) and a second set of conductors (29) interconnecting the first set of connection terminals (16) with the fifth set of connection terminals (24).

12. The IO signal handling arrangement (10) according to claim 11, further comprising at least one field device in a first group of field devices (72A) connected to the first base plate (12A) via the fifth set of connection terminals (24).

13. A process control system (64) comprising the IO signal handling arrangement (10) according to any previous claim.

14. The process control system (64) according to claim 13, further comprising a controller (66) connected to the IO bus (62) for communicating with the first IO module (42A).

15. The process control system (64) according to claim 14, further comprising an IO fieldbus/network interface (70), wherein the controller (66) is connected to a first side of the IO fieldbus/network interface (70) via a network or a field bus (68) and the IO bus (62) is connected to a second side of the IO fieldbus/network interface (70).
